Europäisches Patentamt

European Patent Office

Office européen des brevets

(19)

(11) **EP 0 595 677 B1**

(12) **FASCICULE DE BREVET EUROPEEN**

(45) Date de publication et mention
de la délivrance du brevet:
**30.08.2000 Bulletin 2000/35**

(51) Int. Cl.[7]: **H02H 9/08**

(21) Numéro de dépôt: **93402490.2**

(22) Date de dépôt: **08.10.1993**

(54) **Procédé et dispositif de mesure de l'accord et du désaccord de compensation d'un réseau de distribution électrique**

Verfahren und Vorrichtung zum Messen der Anpassung und Fehlanpassung der Kompensation eines Stromversorgungsnetzes

Method and device for measuring match and mismatch of compensation of an electric distribution network

(84) Etats contractants désignés:
**AT CH DE DK ES GB IE IT LI NL PT SE**

(30) Priorité: **26.10.1992 FR 9212756**

(43) Date de publication de la demande:
**04.05.1994 Bulletin 1994/18**

(73) Titulaire:
**ELECTRICITE DE FRANCE**
**Service National**
**75008 Paris (FR)**

(72) Inventeur: **Bergeal, Jean**
**F-91120 Palaiseau (FR)**

(74) Mandataire:
**Obolensky, Michel et al**
**c/o CABINET LAVOIX**
**2, place d'Estienne d'Orves**
**75441 Paris Cédex 09 (FR)**

(56) Documents cités:
**EP-A- 0 061 704          EP-A- 0 267 500**
**WO-A-86/03350          DE-A- 2 735 756**
**DE-C- 896 387          FR-A- 879 716**
**FR-A- 2 573 256**

## Description

La présente invention concerne les réseaux de distribution électrique du type compensés, c'est-à-dire qu'ils comportent une bobine de compensation ou bobine de Petersen qui permet de compenser le courant capacitif dû aux capacités réparties de la ligne ; la bobine de compensation permet d'obtenir l'équilibre c'est-à-dire une parfaite compensation des impédances capacitives de la ligne.

L'invention a plus particulièrement pour objet un procédé et un dispositif permettant de mesurer le désaccord de la compensation du réseau ; en effet, lorsque l'impédance capacitive propre du réseau varie, du fait par exemple, de la connexion ou de la déconnexion d'utilisateurs importants, la bobine de compensation est désaccordée, c'est-à-dire qu'elle ne compense plus exactement la capacité globale du réseau. Dans un tel cas, il est avantageux de faire varier la valeur de l'impédance de la bobine de compensation de manière à rétablir l'équilibre.

Il a déjà été proposé, pour détecter et mesurer le déséquilibre de la compensation d'un réseau, d'injecter dans le circuit du neutre un courant électrique dont la fréquence est légèrement différente de la fréquence du réseau ; du fait de l'apparition d'un phénomène de battement, on peut alors détecter et mesurer le déséquilibre du reseau. Ce procédé est relativement complexe et nécessite un équipement important, en particulier un générateur de fréquence différente de celle du réseau. De plus, ce type de fonctionnement nécessite des durées importantes de réglage et de mesure.

D'après DE-C-896 387, on connaît un dispositif de réglage automatique de circuits résonnants en particulier de circuits pourvus de bobines de mise à la terre réglables, dans lequel une tension auxiliaire est appliquée au circuit résonnant, la fréquence de la tension auxiliaire correspondant à la fréquence du réseau et, quand une tension est présente au point neutre lors de l'application simultanée de la tension auxiliaire, on inverse périodiquement la tension auxiliaire.

D'après FR-A-879 716, on connaît un procédé et un dispositif de contrôle de circuits électriques, en particulier de bobines d'extinction dans les réseaux à haute tension.

Selon ce procédé, on utilise pour la mesure du degré de compensation ou d'une grandeur qui est avec lui dans une relation simple, une tension de mesure superposée à celle du réseau ayant la même fréquence que lui et dont on fait varier l'amplitude à une fréquence faible par rapport à celle du réseau, la phase de la tension de mesure restant fixe.

Il a également été proposé, comme décrit dans le brevet européen 235 145 de prévoir un dispositif qui permet d'ajouter un complément de réactance entre le neutre et la terre du réseau et de calculer ensuite les paramètres d'atténuation, de dissymétrie et de déséquilibre du réseau. Le branchement d'un complément de réactance entre le neutre et la terre peut être obtenu par commutation d'impédance en parallèle ou en série avec la bobine de compensation ou même, dans le cas où le réseau comporte une bobine de compensation variable, par action sur la bobine de compensation elle-même.

Ce procédé présente l'inconvénient que le temps de réponse de la mesure ainsi effectué est élevé, il peut être de l'ordre de quelques minutes ; la précision de la mesure n'est pas très bonne, spécialement si la dissymétrie est faible, et ce procédé ne peut pas fonctionner de manière fiable dans toutes les conditions d'exploitation d'un réseau.

L'invention a pour but de fournir un procédé et un dispositif de mesure du déséquilibre de la compensation d'un réseau de distribution électrique compensé par une bobine de compensation, qui présentent un temps de réponse court, qui soient de faible prix de revient et qui fonctionnent en toute circonstance indépendamment de la dissymétrie naturelle du réseau.

A cet effet l'invention a pour objet un procédé de mesure du déséquilibre de la compensation d'un réseau de distribution électrique comportant une bobine de compensation, caractérisé en ce que l'on injecte un signal auxiliaire de mesure à la fréquence du réseau dans le circuit du neutre du réseau, en ce que l'on mesure la variation de la tension homopolaire induite par ladite injection de signal auxiliaire et en ce que l'on réalise une mesure d'impédance par comparaison, en amplitude et en déphasage, de la variation de la tension homopolaire avec le signal auxiliaire de mesure.

Il s'agit d'une mesure comportant un système actif dont le temps de réponse est nettement plus faible que les solutions mettant en oeuvre des variations de l'impédance de neutre. Par ailleurs, ce procédé peut être mis en oeuvre de manière simple.

Selon un premier mode de réalisation, le signal auxiliaire injecté est une tension auxiliaire de mesure injectée en série avec la bobine de compensation.

Avantageusement la tension auxiliaire de mesure est injectée au moyen d'un transformateur dont le secondaire est branché en série avec la bobine de compensation.

Selon un autre mode de réalisation, le signal auxiliaire injecté est un courant injecté dans le circuit du neutre en parallèle avec la bobine de compensation.

Avantageusement le courant auxiliaire de mesure est injecté dans le circuit du neutre au moyen d'un transformateur homopolaire.

Ce mode de réalisation est particulièrement avantageux car il ne nécessite que l'implantation de très peu d'éléments, en particulier lorsque le transformateur homopolaire existe déjà sur la bobine.

L'invention a donc également pour objet un dispositif comportant une source de courant branchée en série dans le circuit primaire d'un transformateur homopolaire et destinée à injecter le signal auxiliaire de mesure à la fréquence du réseau dans le circuit neutre du réseau, des moyens de commutation pour la mise en circuit de ladite source lors de la détection d'une variation de tension homopolaire et des moyens pour mesurer la variation de la tension homopolaire induite par le signal auxiliaire injecté et réaliser une d'impédance par comparaison en amplitude et en déphasage, de la variation de la tension homopolaire avec le signal auxiliaire de mesure.

D'autres caractéristiques et avantages de l'invention ressortiront de la description qui suit d'exemples de réalisation de l'invention, faite en se référant aux dessins annexés sur lesquels :

- la figure 1 est le circuit équivalent d'un réseau compensé ;
- la figure 2 illustre le principe d'injection d'un signal de mesure ;
- la figure 3 est un schéma d'un dispositif d'injection d'une tension en série ;
- la figure 4 est le schéma d'un dispositif d'injection d'un courant en parallèle , et
- la figure 5 est le schéma d'un mode de réalisation de l'invention.

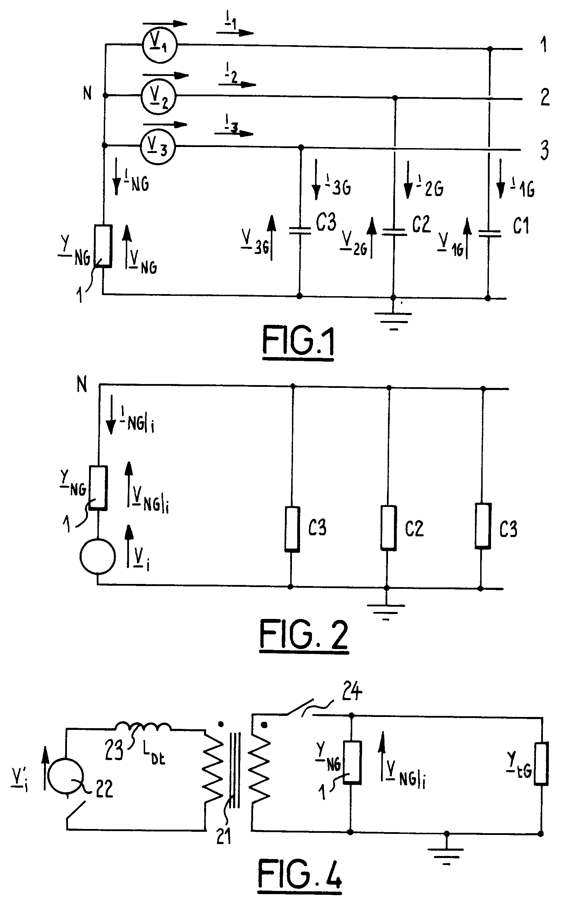

La figure 1 représente le circuit équivalent d'un réseau de distribution électrique compensé. Les réseaux compensés sont équipés d'une impédance de neutre 1, ou bobine de compensation réactive qui est branchée entre le neutre de la source de tension et la terre. Dans le cas d'un défaut monophasé, le courant réactif traversant cette bobine de compensation permet de compenser le courant capacitif du réseau de manière à limiter le courant de défaut.

Sur la figure 1, les capacités réparties du réseau sont représentées par des condensateurs C1 et C2 et C3.

Lorsque le réseau est en service normal, c'est-à-dire qu'il ne comporte pas de défaut, la tension entre le neutre et la terre est déterminée par trois paramètres fondamentaux, le désaccord m, l'asymétrie $\underline{k}$ et l'amortissement d. La tension normalisée neutre-terre $\underline{v}NG$ s'écrit alors :

$$\underline{v}_{NG} = \frac{V_{NG}}{V_{nom}} = \frac{k}{m + jd} \qquad (1)$$

$V_{nom}$ étant la tension simple nominale du réseau, c'est-à-dire la tension entre une phase et le neutre et $\underline{V}Ng$ étant la tension aux bornes de la bobine de compensation 1.

Conformément à l'invention, on injecte un signal auxiliaire de mesure dans le circuit neutre-terre du réseau. Les paramètres désignés ci-dessus sont alors calculés à partir de la comparaison du signal injecté et de la variation de la tension neutre-terre provoquée par cette injection, par application du théorème de superposition.

On mesure ainsi, en amplitude et en phase, la nouvelle impédance du circuit neutre-terre (en réalisant une analyse vectorielle de $\Delta\frac{V}{\Delta I}$ ) et on peut alors déterminer la variation à réaliser sur la bobine 1 pour rétablir l'équilibre du réseau.

Ceci est schématisé sur la figure 2 où l'on retrouve la bobine de compensation 1 et les impédances réparties de chaque phase C1,C2,C3.

Le procédé selon l'invention consiste à injecter une tension de mesure $\underline{V}_i$ en série avec la bobine de compensation 1.

L'influence de la tension injectée en série avec la bobine se traduit par l'équation suivante :

$$\underline{V}_{NG}|_i = \frac{1}{m + jd} \underline{V}_i \qquad (2)$$

on mesure la variation de la tension $\underline{V}_{NG}$ en fonction de la tension injectée et on peut en déduire le désaccord m de la ligne, ce qui permet de calculer la valeur dont il faut faire varier l'impédance de la bobine 1 pour obtenir de nouveau l'équilibre.

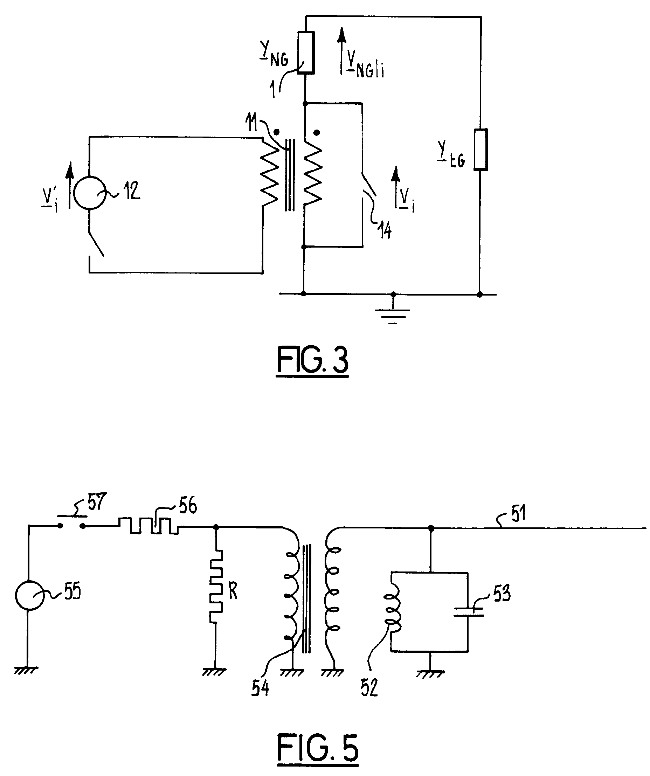

Le signal de mesure peut être injecté de deux manières. On peut tout d'abord injecter une tension en série avec la bobine 1, ce qui nécessite de brancher en série avec ladite bobine un transformateur d'injection 11; comme représenté sur la figure 3. Les caractéristiques de ce transformateur doivent être les suivantes :

- la tenue en tension doit correspondre à la tension maximale possible lors d'un défaut monophasé franc pour la configuration la plus défavorable du réseau;
- la tenue en courant doit correspondre au courant maximal possible circulant dans le neutre, également dans le cas d'un défaut monophasé franc.

Le primaire du transformateur 11 est alimenté par une source de tension 12.

Le transformateur 11 peut par exemple être un tore. Le circuit primaire doit être conçu de manière à résister aux contraintes de tension et de courant dans le cas d'un défaut monophasé du réseau. Un interrupteur 14 permet de court-circuiter le transformateur d'injection du côté secondaire si le dispositif n'est pas en service.

Selon un deuxième mode de réalisation, l'injection du signal de mesure s'effectue par injection d'un courant parallèle dans la bobine neutre 1. Ceci est représenté à la figure 4.

L'injection d'un courant supplémentaire nécessite l'utilisation d'un transformateur d'injection 21 qui doit satisfaire aux conditions suivantes :

- la tenue en tension doit correspondre à la tension maximale possible aux bornes de la bobine 1, c'est-à-dire la tension nominale simple $V_{nom}$ dans le cas d'un défaut monophasé franc ;

- la tenue en courant doit correspondre au courant maximal qui doit être injecté dans le réseau.

Le primaire du transformateur 21 est alimenté par une source de tension 22 en série avec une impédance 23. Ces deux éléments peuvent être variables et/ou commutables ; cette configuration permet également de faire varier l'impédance totale de la liaison neutre-terre pour effectuer des mesures complémentaires sans injecter un signal de mesure.

Ce deuxième mode de réalisation de l'invention présente l'avantage que le transformateur d'injection ne doit supporter que des contraintes plus faibles que dans le cas de l'injection d'une tension en série avec la bobine 1.

Par ailleurs, dans le cas d'un défaut monophasé apparaissant dans le réseau, dans le premier mode de réalisation, un courant important est induit au primaire du transformateur d'injection ce qui amène encore à surdimensionner ce transformateur ainsi que la source auxiliaire.

Un autre inconvénient réside dans le fait que dans le cas de l'injection d'une tension, la mesure est effectuée sur un circuit résonant série et non un circuit résonant parallèle comme dans le cas de l'injection d'un courant de mesure. L'amplification à la résonance n'est pas maîtrisée et peut provoquer, alors, l'apparition d'une tension homopolaire importante et néfaste.

La figure 5 représente un exemple de réalisation de l'invention utilisant le principe de l'injection d'un courant de mesure.

Sur cette figure on a schématisé en 51 un réseau moyenne tension à 12000 V phase-neutre (20 kV entre phases) alimentant un réseau basse tension de 400 V avec sa bobine de compensation 52 et son impédance répartie 53. Ce réseau comporte, comme cela est fréquemment le cas, un transformateur homopolaire 54 disposé au niveau du poste de distribution et qui utilise le noyau magnétique de la bobine de point neutre. Ce transformateur homopolaire 54 est utilisé pour injecter le courant de mesure qui est fourni par exemple par une source auxiliaire de tension 55 constituée par exemple par la tension des auxiliaires du poste, soit 220 V, branchée en série avec une résistance 56 de quelques dizaines d'ohms, par exemple 20 ohms.

La résistance R branchée du côté secondaire du transformateur 54 symbolise la résistance d'amortissement du côté basse tension pour un courant de 20 A du côté moyenne tension. Si la composante active du courant en moyenne tension est de 20 A, la résistance d'amortissement, du côté moyenne tension, est de 600 ohms. Si le rapport de transformation du transformateur homopolaire 54 est égal à 30, ceci correspond à une résistance R d'amortissement du côté basse tension égale à 0,66 ohm.

Si la résistance d'injection 56 est égale à 20 ohms et si la source de tension 55 fournit une tension de 220 V, on obtient un courant de 10,6 A, ce qui entraîne une tension d'environ 7 V sur la résistance d'amortissement en basse tension R à l'accord ; ceci correspond à 1,75% en tension homopolaire (valeur relative à la tension nominale).

S'il existe un désaccord par surcompensation correspondant à une intensité de 100 A, par exemple, la variation induite de la tension homopolaire sera divisée par 5 c'est-à-dire qu'elle correspondra à 0,35%, c'est-à-dire une valeur encore facile à mesurer. Du côté de la basse tension (tension nominale sur défaut franc 400 V), ceci se traduira alors par une mesure d'une variation de tension de 1,4 V sur une tension homopolaire qui, au maximum, est de l'ordre de 24 V, c'est-à-dire 6% de la tension homopolaire maximale hors défaut, en régime normal de fonctionnement.

Si maintenant il existe un désaccord par sous-compensation, il y a la possibilité d'un accord en série entre la réactance de fuite du transformateur homopolaire 54 et la capacité résiduelle du désaccord du côté moyenne tension. Ceci n'est pas gênant car on effectue une injection de courant par une source du côté basse tension; ceci doit éventuellement être pris en compte dans le calcul de la remise en accord du réseau par une mesure de la tension homopolaire vraie mesurée en moyenne tension.

Dans le cas d'un défaut du côté de la moyenne tension, la tension obtenue est de 400 V éventuellement en opposition avec la source auxiliaire de 220 V. Il en résulte que le courant circulant dans le circuit d'injection sera de 30 A. Par conséquent, le contacteur 57 de mise en route du circuit de mesure doit être dimensionné pour un courant de 30 A et une tension de 620 V.

La mesure de la variation de la tension homopolaire peut, dans le cas de la figure 5, être effectuée du côté basse tension ou du côté moyenne tension.

On voit que l'invention permet d'obtenir de manière rapide, c'est-à-dire avec un temps de réponse qui est inférieur à la seconde, une mesure du désaccord du réseau de manière à permettre éventuellement un accord automatique en agissant sur la bobine de compensation.

De plus, l'invention ne nécessite aucunement de mesurer la dissymétrie, comme cela est le cas dans le dispositif décrit dans le brevet européen cité ci-dessus, ce qui rend ainsi la mesure très facile.

Par ailleurs, le procédé selon l'invention élimine, par rapport au dispositif connu actuellement, la nécessité d'effectuer des commutations au niveau de la bobine de compensation. Ceci est particulièrement important car, selon le type de bobine de compensation utilisée, il peut se produire que lors d'une commutation, il n'y a plus du tout de compensation. Ceci est particulièrement défavorable car très souvent, il se produit plusieurs défauts dans un court laps de temps, par exemple dans le cas de coups de foudre ou d'orage.

Par ailleurs le fait que l'on n'effectue pas de commutation sur la bobine de compensation permet de diminuer très notablement le prix de cette dernière.

Le dispositif de mesure selon l'invention est normalement débranché et il n'est mis en oeuvre par action sur le contacteur 57 que lorsque l'on a détecté une variation de la tension homopolaire. On fait alors une mesure par injection de courant et si l'on conclut à un déséquilibre du réseau, on calcule la compensation à effectuer et on la réalise en agissant par exemple au niveau de la bobine 1.

Un autre avantage de l'invention par rapport au dispositif connu par le brevet européen précité dans lequel on fait varier l'impédance de mise à la terre, est que, dans le dispositif connu, la résistance du circuit neutre-terre doit rester constante. Dans le dispositif selon l'invention, il n'y a pas de modification de l'impédance de la mise à la terre et par conséquent la mesure n'est pas faussée.

Ceci est particulièrement vrai si, lors d'une commutation de prises de la bobine ou de tout autre variation, son facteur de qualité varie.

L'influence sur la précision de la mesure de l'accord permettra de réduire le coût des bobines dans un rapport qui pourra atteindre 5.

Un autre avantage de l'invention est que lorsque l'on injecte le signal de mesure, on produit une variation de la tension homopolaire qui est disponible sur l'ensemble de la ligne de distribution et constitue donc une sorte de signal "à courant porteur" qui peut être utilisé par un poste quelconque disposé sur la ligne pour y effectuer des télécommandes.

Le dispositif selon l'invention est très économique; dans l'exemple de réalisation, il ne nécessite que le branchement d'une tension d'auxiliaires disponible dans un poste de distribution, un contacteur et une résistance qui peut être aussi facile à se procurer que celles utilisées dans les radiateurs de chauffage électrique.

## Revendications

1. Procédé de mesure de l'accord et du désaccord de la compensation d'un réseau de distribution électrique comportant une bobine de compensation (1), caractérisé en ce que l'on injecte un signal auxiliaire de mesure à la fréquence du réseau dans le circuit du neutre du réseau, en ce que l'on mesure la variation de la tension homopolaire induite par ladite injection de signal auxiliaire et en ce que l'on réalise une mesure d'impédance par comparaison, en amplitude et en déphasage, de la variation de la tension homopolaire avec le signal auxiliaire de mesure.

2. Procédé selon la revendication 1, caractérisé en ce que le signal auxiliaire injecté est une tension auxiliaire de mesure injectée en série avec la bobine de compensation (1).

3. Procédé selon la revendication 1, caractérisé en ce que le signal auxiliaire est un courant injecté dans le circuit du neutre en parallèle avec la bobine de compensation (1).

4. Procédé selon la revendication 3, caractérisé en ce que le courant auxiliaire de mesure est injecté dans le circuit du neutre au moyen d'un transformateur homopolaire (54).

5. Procédé selon la revendication 3, caractérisé en ce que le courant auxiliaire de mesure (21) est injecté au moyen d'un transformateur de mesure dont le secondaire est branché sur la bobine de compensation (1).

6. Procédé selon la revendication 2, caractérisé en ce que la tension auxiliaire de mesure est injectée au moyen d'un transformateur (11) dont le secondaire est branché en série avec la bobine de compensation (1).

7. Dispositif pour la mise en oeuvre du procédé selon la revendication 3, caractérisé en ce qu'il comporte une source de courant (55,56) branchée en série dans le circuit primaire d'un transformateur homopolaire et destinée à injecter le signal auxiliaire de mesure à la fréquence du réseau dans le circuit neutre du réseau, des moyens de commutation (57) pour la mise en circuit de ladite source lors de la détection d'une variation de tension homopolaire, et des moyens pour mesurer la variation de la tension homopolaire induite par le signal auxiliaire injecté et réaliser une mesure d'impédance par comparaison an amplitude et an déphasage, de la variation de la tension homopolaire avec le signal auxiliaire de mesure.

8. Dispositif selon la revendication 7, caractérisé an ce que ladite source de courant est obtenue à partir de la tension auxiliaire du poste de commande du réseau.

9. Dispositif selon la revendication 8, caractérisé en ce que le transformateur homopolaire a un enroulement secondaire débitant an cas de défaut franc du réseau une tension de niveau basse tension et an ce que la source de courant est constituée par une résistance de quelques dizaines d'ohms alimentée par la tension auxiliaire du poste.

**Claims**

1. Method for measuring match and mismatch of compensation of an electric distribution network comprising a compensating coil (1), characterised in that an auxiliary test signal is input into the neutral circuit of the network at the frequency of the network, in that the variation in the unipolar voltage which is induced by said input of the auxiliary signal is measured, and in that the impedance is measured by comparing, in amplitude and phase displacement, the variation in the unipolar voltage with the auxiliary test signal.

2. Method according to claim 1, characterised in that the input auxiliary signal is an auxiliary measuring voltage which is input in series with the compensating coil (1).

3. Method according to claim 1, characterised in that the auxiliary signal is a current which is input into the neutral circuit in parallel with the compensating coil (1).

4. Method according to claim 3, characterised in that the auxiliary measuring current is input into the neutral circuit by means of a unipolar transformer (54).

5. Method according to claim 3, characterised in that the auxiliary measuring current (21) is input by means of an instrument transformer, the secondary winding of which is connected to the compensating coil (1).

6. Method according to claim 2, characterised in that the auxiliary measuring voltage is input by means of a transformer (11), the secondary winding of which is connected in series with the compensating coil (1).

7. Device for implementing the method according to claim 3, characterised in that it comprises a current source (55, 56) which is connected in series into the primary circuit of a unipolar transformer and is intended for input of the auxiliary test signal into the neutral circuit of the network at the frequency of the network, means of commutation (57) for connecting said source into the circuit during detection of a unipolar voltage variation, and means of measuring the variation in unipolar voltage induced by the input auxiliary signal and of carrying out a measurement of impedance by comparing, in amplitude and phase displacement, the variation in unipolar voltage with the auxiliary test signal.

8. Device according to claim 7, characterised in that said current source is obtained from the auxiliary voltage of the network control station.

9. Device according to claim 8, characterised in that the unipolar transformer has a secondary winding which, in the case of a clear fault in the network, delivers a voltage at low voltage level, and in that the current source comprises a resistance of a few tens of ohms and is applied by the auxiliary voltage of the control station.

**Patentansprüche**

1. Verfahren zur Messung der Anpassung und Fehlanpassung der Kompensation eines Stromversorgungsnetzes, welches eine Kompensationsspule (1) aufweist, dadurch gekennzeichnet, daß ein Hilfsmeßsignal mit der Netzfrequenz auf den Nullkreis des Netzes gegeben wird, daß die Änderung der gleichpoligen Spannung gemessen wird, die durch das Aufgeben des Hilfssignals bewirkt wird, und daß eine Impedanzmessung durch Vergleich, in Amplude und Phasenverschiebung, der Änderung der gleichpoligen Spannung mit dem Hilfsmeßsignal durchgeführt wird.

2. Verfahren nach Anspruch 1, dadurch gekennzeichnet, daß das aufgegebene Hilfssignal eine Hilfsmeßspannung ist, die in Reihe mit der Kompensationsspule (1) aufgegeben wird.

3. Verfahren nach Anspruch 1, dadurch gekennzeichnet, daß das Hilfssignal ein Strom ist, der auf den Nullkreis parallel zur Kompensationsspule (1) aufgegeben wird.

4. Verfahren nach Anspruch 3, dadurch gekennzeichnet, daß der Hilfsmeßstrom auf den Nullkreis mittels eines gleichpoligen Transformators (54) aufgegeben wird.

5. Verfahren nach Anspruch 3, dadurch gekennzeichnet, daß der Hilfsmeßstrom (21) mittels eines Meßwandlers aufgegeben wird, dessen Sekundärwicklung in Reihe mit der Kompensationsspule (1) geschaltet ist.

6. Verfahren nach Anspruch 2, dadurch gekennzeichnet, daß die Hilfsmeßspannung mittels eines Transformators (11) aufgegeben wird, dessen Sekundärwicklung in Reihe mit der Kompensationsspule (1) geschaltet ist.

7. Vorrichtung zur Durchführung des Verfahrens nach Anspruch 3, dadurch gekennzeichnet, daß sie eine Stromquelle (55, 56), die in Reihe in den Primärkreis eines gleichpoligen Transformators geschaltet und für ein Aufgeben des Hilfsmeßsignals mit der Netzfrequenz auf den Nullkreis des Netzes bestimmt ist, Schaltmittel (57) zum Schalten der Quelle in den Kreis bei Feststellung einer gleichpoligen Spannungsänderung und Mittel zum Messen der Änderung der gleichpoligen Spannung, die durch das auf gegebene Hilfssignal bewirkt wird, und zum Durchführen einer Impedanzmessung durch Vergleich, in Amplitude und Phasenverschiebung, der Änderung der gleichpoligen Spannung mit dem Hilfsmeßsignal aufweist.

8. Vorrichtung nach Anspruch 7, dadurch gekennzeichnet, daß die Stromquelle anhand der Hilfsspannung des Steuerstands des Netzes gewonnen ist.

9. Vorrichtung nach Anspruch 8, dadurch gekennzeichnet, daß der gleichpolige Transformator eine Sekundärwicklung aufweist, die im Falle eines stetigen Netzfehlers eine Spannung auf Niedrigspannungsniveau abgibt, und daß die Stromquelle durch einen Widerstand von mehreren zehn Ohm gebildet ist, der mit der Hilfsspannung des Steuerstands gespeist wird.

FIG.1

FIG. 2

FIG. 4

$\underline{Y}_{NG}$

$\underline{V}_{NGli}$

1

$\underline{V}'_i$

12

11

$\underline{Y}_{tG}$

$\underline{V}_i$

14

## FIG.3

57

56

55

R

53

54

52

51

## FIG.5